# FASCICULE DE BREVET EUROPEEN

(11) **EP 3 113 860 B1**
(45) Date de publication et mention de la délivrance du brevet: **13.05.2020**
(21) Numéro de dépôt: 15713976.7
(22) Date de dépôt: 04.03.2015
(51) Int. Cl.: B01D 53/14, C23C 16/44

(54) **PROCEDE DE TRAITEMENT DE GAZ EFFLUENT CONTENANT DES HYDROCARBURES AROMATIQUES POLYCYCLIQUES**
VERFAHREN ZUR BEHANDLUNG VON ABGAS ENTHALTEND POLYZYKLISCHE AROMATISCHE KOHLENWASSERSTOFFE
METHOD FOR TREATING WASTE GAS CONTAINING POLYCYCLIC AROMATIC HYDROCARBONS

(30) Priorité: 05.03.2014 FR 1451793
(43) Date de publication de la demande: 11.01.2017
(73) Titulaire: Safran Ceramics, 33185 Le Haillan (FR)
(72) Inventeur: POTIN, Jean-François, F-33700 Merignac (FR); DELPERIER, Bernard, F-33700 Merignac (FR)
(74) Mandataire: Cabinet Beau de Loménie
(86) Numéro de dépôt international: PCT/FR2015/050523
(87) Numéro de publication internationale: WO 2015/132527

(56) Documents cités:
- WO-A1-2010/085244
- WO-A2-03/047725
- US-A- 5 019 143
- US-A- 5 406 802

## Description

La présente invention concerne le traitement de gaz effluent contenant des hydrocarbures aromatiques polycycliques.

Le domaine d'application de l'invention est plus particulièrement celui du traitement de gaz effluent produit par des installations industrielles de dépôt ou infiltration chimique en phase vapeur pour la formation de dépôt de carbone pyrolytique sur des substrats ou pour la densification de substrats poreux par une matrice de carbone pyrolytique.

De telles installations sont très bien connues. Des substrats à revêtir ou à densifier par du carbone pyrolytique sont placés dans un four dans lequel un gaz réactif contenant un ou plusieurs précurseurs du carbone est introduit. Le gaz précurseur est un hydrocarbure, typiquement du méthane, du propane ou un mélange des deux. La pression et la température dans le four sont réglées pour produire le revêtement ou la matrice de carbone pyrolytique par décomposition (craquage) du gaz précurseur au contact des substrats. Le gaz effluent contenant des sous-produits de réaction est extrait du four par pompage de façon continue.

Les sous-produits de réaction comprennent des composés organiques qui ont une température de solidification assez élevée, en particulier des hydrocarbures aromatiques polycycliques (HAP) tels que, notamment, le naphtalène, le pyrène, l'anthracène, l'acénaphtylène,... Une liste des HAP est indiquée dans le tableau ci-dessous :

| HAP | N° CAS |
|---|---|
| Naphtalène | 91-2062 |
| Acénaphtylène | 208-96-8 |
| Acenaphtalène | 83-32-9 |
| Fluorène | 86-73-7 |
| Anthracène | 120-12-7 |
| Phénanthrène | 85-01-08 |
| Fluoranthene | 206-44-0 |
| Pyrène | 129-00-0 |
| Benzo(a)anthracène | 56-55-3 |
| Chrysène | 218-01-9 |
| Benzo(a)pyrène | 50-32-8 |
| Benzo(b)fluoranthene | 205-99-2 |
| Dibenzo(ah)anthracene | 53-70-3 |
| Benzo(k)fluoranthene | 207-08-9 |
| Benzo(ghi)pérylene | 191-24-2 |
| Indeno(123ed)pyrene | 193-39-5 |

Par condensation, ces sous-produits de réaction forment des goudrons qui ont tendance à se déposer dans les canalisations de sortie du four lorsque le gaz effluent se refroidit. Ces goudrons se retrouvent également dans le dispositif de pompage, par exemple dans l'huile de pompes à vide ou dans les condensats d'éjecteurs à vapeur.

Des problèmes similaires peuvent être rencontrés avec des installations industrielles autres que des fours de dépôt ou d'infiltration chimique en phase gazeuse utilisant des hydrocarbures comme gaz réactif, par exemple des fours de cémentation.

Il est connu d'après la demande WO 03/047725 d'utiliser une huile minérale aromatique pour traiter le gaz effluent contenant des goudrons et en particulier des hydrocarbures aromatiques polycycliques (HAP) par une étape de lavage par pulvérisation de cette huile. Le piégeage des HAP est suivi par élévation du niveau dans le piège à goudrons. A partir d'un certain seuil de HAP capturés, l'huile chargée en HAP est enlevée pour être remplacée par de l'huile neuve; le seuil actuel est à environ 30% de reprise en volume. En poursuivant l'utilisation de l'huile nous avons montré que l'efficacité du piégeage se maintient jusqu'à plus de 60% en volume. Malheureusement, même si le piégeage peut se maintenir jusqu'à ces niveaux, les caractéristiques physico-chimiques de l'huile chargée en HAP évolue au cours du temps en fonction de sa teneur en HAP (densité, viscosité). En particulier sa viscosité va augmenter jusqu'à des valeurs inacceptables qui empêcheront son pompage et sa pulvérisation. La durée d'utilisation de cette huile minérale aromatique est donc limitée, ce qui oblige à la remplacer et donc rend le procédé onéreux.

La demande de brevet WO2010/085244 décrit l'utilisation d'huile alimentaire pour éliminer les HAP de gaz. Toutefois, ce type d'huile présente le désavantage de se dégrader thermiquement. Ainsi, il est nécessaire de refroidir le gaz avant son lavage par l'huile de façon à obtenir une température de lavage inférieure à 80°C et même inférieure à 50°C ([0023] page 7). Les huiles naphténiques sont citées dans le tableau 1 page 14 de ce document mais ne sont pas considérées comme intéressantes en raison du faible taux de solubilité des HAP dans ces huiles.

La demande US5019143 décrit l'utilisation de différents solvants choisis dans le groupe constitué par les solvants paraffiniques, les solvants naphténiques, les composés aromatiques ou d'autres solvants pour extraire l'éthylène d'un gaz contenant également des hydrocarbures insaturés et saturés plus lourds. Toutefois les solvants naphténiques cités ne sont pas des huiles naphténiques. En outre ce document n'incite pas à mélanger les différents types de solvants. De plus ce document n'indique à aucun moment que le gaz à traiter contient des HAP. Enfin la pression de mise en œuvre du procédé est très élevée (entre 50 et 400 psi soit entre 0,34MPa et 2,76MPa).

Les inventeurs ont découvert qu'il était possible d'ajouter une huile aromatique naphténique à l'huile minérale aromatique pour diminuer sa viscosité et permettre une utilisation plus longue de cette huile, sans toutefois gêner sa capacité de piégeage des HAP. Cette huile minérale, permet d'abaisser la viscosité de l'huile minérale aromatique ce qui permet de prolonger sa durée d'utilisation.

La présente invention concerne donc un procédé de traitement de gaz effluent contenant des hydrocarbures aromatiques polycycliques comprenant une étape de lavage par pulvérisation d'une huile minérale afin de piéger lesdits hydrocarbures, caractérisé en ce que l'huile minérale comprend (avantageusement est constituée par) un mélange d'huile minérale aromatique et d'huile minérale naphténique telle que revendiquée dans la revendication 1.

Par rapport à d'autres techniques de lavage de gaz, le lavage par pulvérisation permet de limiter la perte de charge subie par le gaz et de minimiser la formation de dépôts de goudrons sur des parois, comme cela pourrait être le cas avec l'utilisation de colonnes de lavage à plateaux. Dans un mode de réalisation avantageux, l'étape de lavage est réalisée à une pression comprise entre 1x10³ et 1x10⁵ Pa, de façon avantageuse à une pression de 1000Pa (10mbars absolu), même si une telle pression ne facilite pas la condensation des HAP ce qui limite l'absorption des HAP par l'huile. Dans un autre mode de réalisation avantageux, l'étape de lavage est réalisée à une température inférieure à 20°C, avantageusement inférieure à 0°C.

Le mélange d'huile comprend au moins 20 % en volume d'huile minérale aromatique par rapport au volume total du mélange, avantageusement au moins 30% en volume d'huile minérale aromatique. La teneur en huile minérale naphténique dépend de la viscosité à atteindre dans le mélange. Le mélange d'huile peut comprendre au plus 80% en volume d'huile minérale naphténique par rapport au volume total du mélange, en particulier au plus 70% en volume d'huile minérale naphténique. Dans un mode de réalisation avantageux, le mélange d'huile comprend au moins 10% en volume d'huile minérale naphténique par rapport au volume total du mélange, en particulier au moins 14% en volume d'huile minérale naphténique, plus particulièrement au moins 20% en volume d'huile minérale naphténique. Le mélange d'huile a une viscosité inférieure ou égale à 150 mm²/s à 0°C. La mesure de la viscosité cinématique d'une huile selon l'invention se fait selon la norme ASTM D445 avec un viscosimètre Ubbelhode avec des capillaires de diamètre 0,88 mm. Les viscosités sont mesurées à 5 et 10°C et la viscosité à 0°C est obtenue par extrapolation linéaire. En effet, la mesure à 0°C n'est pas directement réalisable en raison de la condensation formée à cause de la grande différence de température entre la pièce et le système d'analyse. La constante du viscosimètre est mesurée avec du undécane.

Avantageusement, l'huile minérale aromatique utilisée dans le procédé selon la présente invention est telle que décrite dans la demande de brevet WO 03/047725. En particulier l'huile minérale aromatique doit rester en phase liquide pendant le processus de lavage afin de ne pas produire de vapeur entraînée par le gaz effluent. Dans le cas notamment de gaz effluent de four de dépôt ou d'infiltration chimique en phase gazeuse, la pression du gaz effluent en sortie du four est relativement faible. L'huile utilisée doit donc présenter une tension de vapeur suffisamment faible pour ne pas se vaporiser à la pression régnant en sortie du four, afin de ne pas charger le gaz effluent de vapeur d'huile. A titre indicatif, la pression dans le four lors de différentes phases du processus d'infiltration peut être inférieure à environ 200Pa. L'huile de lavage doit donc avantageusement présenter une faible tension de vapeur, de préférence inférieure à 1 Pa à 0°C. En outre, la composition de l'huile doit permettre une bonne absorption des goudrons à piéger. C'est pourquoi, on choisit de préférence une huile minérale aromatique capable d'absorber et de dissoudre des HAP.
Avantageusement l'huile doit en outre initialement, avant qu'elle ne se charge en HAP, présenter une viscosité suffisamment basse pour être mise en circulation et former un brouillard en sortie des buses, en particulier une viscosité inférieure ou égale à 75 mm²/s à 0°C, plus particulièrement inférieure ou égale à 73 mm²/s à 0°C. La viscosité est mesurée comme indiqué ci-dessus pour le mélange d'huile.
Dans un mode de réalisation avantageux l'huile minérale aromatique est une huile à base de xylènes. Une huile à base de xylènes, telle que l'huile de synthèse commercialisée sous la dénomination "Jaritherm AX 320" par la société française Arkema et constituée à 85 % en poids de mono-xylyxylène et à 15 % en poids de di-xylyxylène, s'est révélée efficace. Cette huile a une viscosité de 73 mm²/s à 0°C et une tension de vapeur à 0°C inférieure à 1 Pa. L'huile minérale aromatique à base de xylène commercialisée par la société TOTAL LUBRIFIANTS sous la dénomination « Jaritherm DBT06» et constitué par un mélange d'isomères de dibenzyltoluène s'est également révélée efficace. De même l'huile aromatique AZOLLA NET HC commercialisée par la société TOTAL LUBRIFIANTS s'est également révélée particulièrement efficace.

L'huile minérale naphténique utilisable selon l'invention peut être un distillat léger raffiné hydrodésulfurisé naphténique Sa teneur en huile paraffinique est avantageusement inférieure à 50 %. De même que pour l'huile minérale aromatique, l'huile minérale naphténique doit de façon avantageuse rester en phase liquide pendant le processus de lavage afin de ne pas produire de vapeur entraînée par le gaz effluent. L'huile utilisée doit donc avantageusement présenter une tension de vapeur suffisamment faible pour ne pas se vaporiser à la pression régnant en sortie du four, afin de ne pas charger le gaz effluent de vapeur d'huile. L'huile minérale naphténique doit donc avantageusement présenter une faible tension de vapeur, de préférence inférieure à 1Pa à 0°C. L'huile minérale naphténique doit en outre de façon avantageuse présenter une viscosité suffisamment basse pour être mise en circulation et former un brouillard en sortie des buses et en même temps abaisser la viscosité de l'huile minérale aromatique lorsque cette dernière est chargée en HAP. Ainsi avantageusement l'huile minérale naphténique a une viscosité inférieure ou égale à 75 mm²/s à 0°C, plus avantageusement inférieure ou égale à 70 mm²/s à 0°C, en particulier inférieure ou égale à 60 mm²/s à 0°C. La viscosité est mesurée comme indiqué ci-dessus pour le mélange d'huile. Ainsi à pression atmosphérique, avantageusement l'huile minérale naphténique selon la présente invention reste liquide à une température ≥200°C, avantageusement ≥210°C, plus avantageusement ≥240°C, encore plus avantageusement ≥250°C. En particulier l'huile minérale naphténique commercialisée par la société TOTAL LUBRIFIANTS sous la dénomination « ISOVOLTINE II » est particulièrement intéressante dans le cadre du procédé selon la présente invention.

Dans une première variante, l'huile minérale naphténique est présente dès le début du procédé. Ainsi l'huile minérale qui servira au lavage du gaz effluent comprend (en particulier est constituée par) dès le départ un mélange d'huile minérale aromatique et d'huile minérale naphténique tel que décrit ci-dessus et a en particulier une viscosité de 70 mm²/s à 0°C.

Dans une deuxième variante, le procédé selon la présente invention comprend une phase d'initiation dans laquelle l'huile minérale ne comprend pas d'huile minérale naphténique et comprend de (en particulier est constitué par) l'huile minérale aromatique, de façon à obtenir une huile minérale aromatique chargée en hydrocarbures aromatiques polycycliques et présentant une viscosité supérieure à 150 mm²/s à 0°C. L'huile minérale naphténique est alors ajoutée à la fin de la phase d'initiation à l'huile minérale chargée en hydrocarbure aromatique polycyclique afin d'en réduire la viscosité.

Dans un mode de réalisation particulièrement avantageux, l'ajout de l'huile minérale naphténique se fait sous la forme d'un mélange d'huile minérale naphténique et d'huile minérale aromatique tel que décrit ci-dessus. Encore plus avantageusement cet ajout se fait par remplacement d'une partie de l'huile minérale aromatique chargée en hydrocarbures aromatiques par la même proportion en volume du mélange d'huile minérale naphténique et d'huile minérale aromatique, plus avantageusement par remplacement d'entre 20 à 35% du volume de l'huile minérale aromatique chargée en hydrocarbures aromatiques polycycliques par la même proportion en volume du mélange d'huile minérale naphténique et d'huile minérale aromatique. Lorsque l'huile naphténique se trouve sous la forme d'un mélange d'huile minérale naphténique et d'huile minérale aromatique, ce mélange peut comprendre au moins 20% en volume d'huile minérale aromatique par rapport au volume total du mélange, avantageusement au moins 30% en volume d'huile minérale aromatique. Il peut également comprendre au plus 80% en volume d'huile minérale naphténique par rapport au volume total du mélange, en particulier au plus 70% en volume d'huile minérale naphténique. De façon avantageuse le mélange d'huile a une viscosité inférieure ou égale à 150mm²/s à 0°C.

Dans ce deuxième cas, on attend donc que l'huile minérale aromatique soit déjà chargée en HAP avant d'ajouter l'huile minérale naphténique. Le procédé comprend donc deux phases : une première phase appelée phase d'initiation où seule l'huile minérale aromatique est utilisée pour le lavage des gaz effluents et une deuxième phase où un mélange d'huile minérale aromatique et d'huile minérale naphténique est utilisé pour ce même lavage.

Dans ces deux variantes, de l'huile minérale naphténique, en particulier sous forme de mélange d'huile minérale naphténique et d'huile minérale aromatique peut être continuellement ajoutée dès que le mélange d'huile utilisé pour le lavage après l'éventuelle phase d'initiation n'a plus la viscosité désirée en raison de son chargement en HAP, (c'est-à-dire a une viscosité supérieure à 150 mm²/s à 0°C), le mélange d'huile utilisé pour le lavage comprenant ainsi une quantité en volume de plus en plus importante d'huile naphténique, jusqu'à ce que cette dernière représente le composant majoritaire de ce mélange, avantageusement au plus 80% en volume du mélange d'huile utilisé pour le lavage, plus particulièrement au plus 70% en volume de ce mélange utilisé pour le lavage.

Dans ces deux variantes, l'étape de lavage est en particulier telle que décrite dans la demande de brevet WO 03/047725. Ainsi donc avantageusement l'étape de lavage du gaz effluent est réalisée par injection de l'huile minérale (soit celle comprenant l'huile minérale aromatique, soit celle comprenant le mélange d'huile minérale aromatique et d'huile minérale naphténique, selon la variante utilisée et la phase du procédé) dans un courant de gaz effluent parcourant une colonne de pulvérisation, par exemple une colonne à venturi.

De façon avantageuse comme décrit dans la demande brevet WO 03/047725, l'huile minérale (soit celle comprenant l'huile minérale aromatique, soit celle comprenant le mélange d'huile minérale aromatique et d'huile minérale naphténique, selon la variante utilisée et la phase du procédé) circule en continu entre un bac de recirculation recueillant l'huile minérale chargée d'hydrocarbures aromatiques polycycliques et au moins une buse de pulvérisation d'huile dans un courant de gaz effluent. L'huile minérale est préférentiellement refroidie sur son trajet entre le bac de recirculation et la ou les buses de pulvérisation. En effet ce refroidissement permet de favoriser la condensation des HAP présents dans le gaz effluent à traiter afin que ces derniers soient entraînés par l'huile minérale lors de la pulvérisation. Ainsi donc avantageusement la température de l'huile minérale à l'arrivée à la buse de pulvérisation est inférieure à 20°C, avantageusement inférieure à 0°C. De façon avantageuse, le gaz effluent à traiter n'est lui pas refroidi avant son arrivée vers le lieu de lavage. Ainsi, avantageusement, la température du gaz effluent à traiter au moment du lavage est inférieure à 200°C.

En particulier le procédé selon la présente invention est caractérisé en ce que le gaz effluent est produit par un procédé de dépôt ou d'infiltration chimique en phase vapeur pour la formation de dépôt de carbone pyrolytique sur des substrats ou pour la densification des substrats poreux par une matrice de carbone pyrolytique. Ces procédés de dépôt et d'infiltration sont bien connus de l'homme du métier.

Dans un mode de réalisation avantageux, le procédé selon l'invention comprend une étape supplémentaire après l'étape de lavage, de passage du gaz effluent dans un dispositif de pompage. N'importe quel système de pompage connu de l'homme du métier peut être utilisé dans la cadre du procédé selon la présente invention. Avantageusement, le pompage du gaz effluent est réalisé par passage du gaz lavé dans au moins un éjecteur- condenseur à vapeur. Avantageusement, au moins une partie du gaz issu de l'éjecteur-condenseur est utilisée comme gaz de combustion pour un dispositif de production de la vapeur alimentant l'éjecteur-condenseur.
Avantageusement encore, le condensat de vapeur en sortie de l'éjecteur-condenseur est traité par passage sur charbon actif afin de récupérer des hydrocarbures légers, notamment benzéniques, et un reliquat éventuel d'HAP contenu dans le condensat...
Une matrice de carbone pyrolytique est formée au sein de la porosité des substrats par décomposition du ou des précurseur (s) gazeux. L'installation utilisable pour la mise en œuvre du procédé selon la présente invention est en particulier décrite dans la demande de brevet WO 03/047725.

De façon avantageuse les hydrocarbures aromatiques polycycliques sont choisis dans la liste indiquée dans le tableau 1 et leurs mélanges, avantageusement parmi le naphtalène, pyrène, anthracène, acénaphtylène et leurs mélanges.

L'invention sera mieux comprise à la lumière des exemples et de la description des figures qui suivent.
La figure 1 représente la viscosité à 5°C d'une huile "Jaritherm AX 320" utilisée dans le procédé décrit par la demande de brevet WO03/047725 en fonction du temps d'utilisation.
La figure 2 représente la viscosité à 5°C d'une huile "Jaritherm AX 320" utilisée dans le procédé décrit par la demande de brevet WO03/047725 en fonction de son chargement en HAP (taux d'HAP en volume).
La figure 3 représente la comparaison entre l'utilisation dans le procédé décrit par la demande de brevet WO03/047725 d'une huile aromatique Jaritherm AX 320 et d'un mélange d'huile comprenant 70% en volume de cette huile et 30% en volume du mélange d'huile naphténique ISOVOLTINE II et d'huile aromatique AZOLLA NET HC, le mélange ajouté ayant les proportions en volume suivantes : 75% d'huile naphténique ISOVOLTINE II et 25% d'huile aromatique AZOLLA NET HC sur la quantité de goudrons captée par litre d'huile en fonction du temps d'utilisation (en heures).
La figure 4 représente la comparaison entre l'utilisation dans le procédé décrit par la demande de brevet WO03/047725 d'une huile aromatique Jaritherm AX 320 décrite dans la demande de brevet WO03/047725 et de l'huile aromatique Jaritherm DBT06 sur la quantité de goudrons captée par litre d'huile en fonction du temps d'utilisation (en heures).

### Exemples de réalisation

Le procédé décrit dans la demande de brevet WO03/047725 est mis en œuvre en utilisant :
- L'huile aromatique Jaritherm AX 320 décrite dans cette demande ;
- L'huile aromatique Jaritherm DBT06;
- Un mélange d'huile comprenant 70% en volume d'une huile aromatique Jaritherm AX 320 et 30% en volume du mélange d'huile naphténique ISOVOLTINE II et d'huile aromatique AZOLLA NET HC, le mélange ajouté ayant les proportions en volume suivantes : 75% d'huile naphténique ISOVOLTINE II et 25% d'huile aromatique

### AZOLLA NET HC

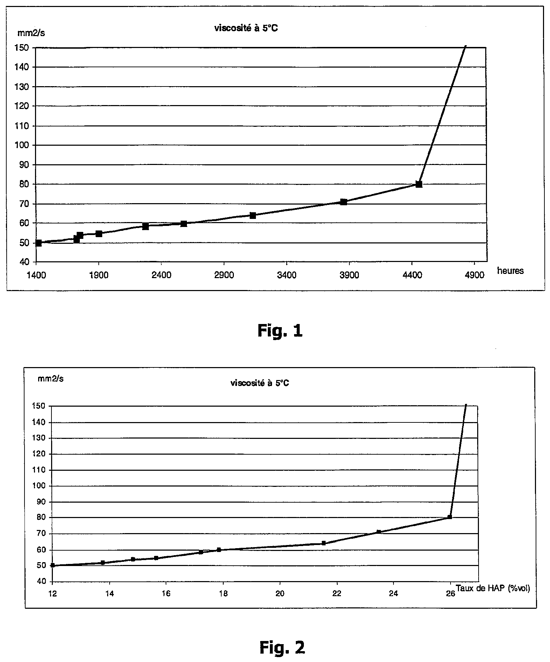

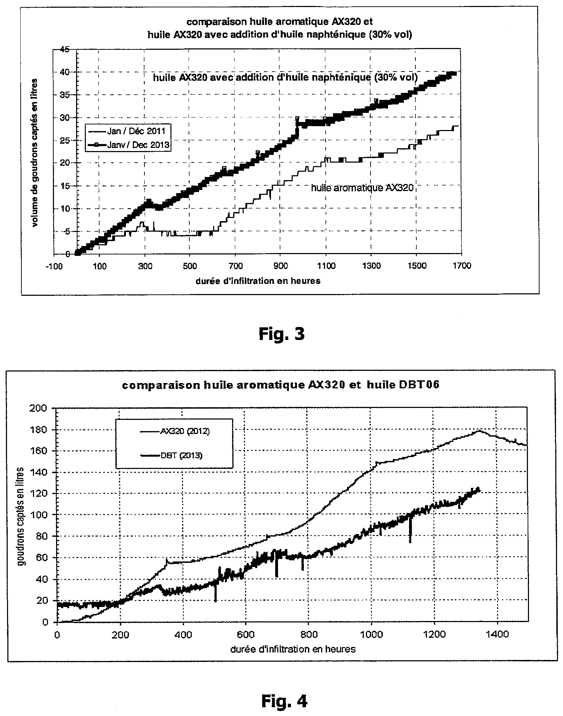

On remarque que les deux huiles aromatiques ont le même comportement (figure 4) et que leur viscosité augmente en fonction du temps d'utilisation et donc de leur taux de HAP (figures 1 et 2).

Par ailleurs, la présence du mélange huile naphténique/ huile aromatique (au moins 30% en volume) et donc d'huile naphténique n'a pas d'impact sur le volume de goudrons captés. Le mélange d'huile peut donc toujours être utilisé de façon efficace pour capter les goudrons et donc les HAP, tout en maintenant une viscosité plus faible (la viscosité de l'huile naphténique est plus faible que celle de l'huile aromatique) ce qui permet d'utiliser le mélange plus longtemps.

## Revendications

1. Procédé de traitement de gaz effluent contenant des hydrocarbures aromatiques polycycliques comprenant une étape de lavage par pulvérisation d'une huile minérale afin de piéger lesdits hydrocarbures, **caractérisé en ce que** l'huile minérale comprend un mélange d'huile minérale aromatique et d'huile minérale naphténique, **en ce que** le mélange d'huile minérale comprend au moins 20% en volume d'huile minérale aromatique par rapport au volume total du mélange et **en ce que** le mélange d'huile a une viscosité inférieure ou égale à 150 mm²/s à 0°C mesurée selon la norme ASTM D445 avec un viscosimètre Ubbelholde avec des capillaires de diamètre 0,88 mm.

2. Procédé selon la revendication 1, **caractérisé en ce que** le mélange d'huile minérale comprend au moins 30% en volume d'huile minérale aromatique.

3. Procédé selon l'une quelconque des revendications 1 ou 2 **caractérisé en ce qu'**il comprend une phase d'initiation dans laquelle l'huile minérale ne comprend pas d'huile minérale naphténique et comprend une huile minérale aromatique, de façon à obtenir une huile minérale aromatique chargée en hydrocarbures aromatiques polycycliques et présentant une viscosité supérieure à 150 mm²/s à 0°C mesurée selon la norme ASTM D445 avec un viscosimètre Ubbelholde avec des capillaires de diamètre 0,88 mm.

4. Procédé selon la revendication 3 **caractérisé en ce que** de l'huile minérale naphténique est ajoutée à l'huile minérale comprenant de l'huile minérale aromatique chargée en hydrocarbures aromatiques polycycliques obtenue durant la phase d'initiation.

5. Procédé selon la revendication 4 **caractérisé en ce que** l'huile minérale naphténique ajoutée se trouve sous la forme d'un mélange d'huile minérale naphténique et d'huile minérale aromatique et que l'ajout se fait par remplacement d'une partie de l'huile minérale aromatique chargée en hydrocarbures aromatiques polycycliques par la même proportion en volume du mélange d'huile minérale naphténique et d'huile minérale aromatique, avantageusement par remplacement d'entre 20 à 35% du volume de l'huile minérale aromatique chargée en hydrocarbures aromatiques polycycliques.

6. Procédé selon la revendication 5 **caractérisé en ce que** le mélange d'huile ajouté contient au moins 20% en volume d'huile minérale aromatique par rapport au volume total du mélange, avantageusement au moins 30% en volume.

7. Procédé selon l'une quelconque des revendications 1 à 6, **caractérisé en ce que** l'huile minérale aromatique a une tension de vapeur inférieure à 1 Pa à 0°C.

8. Procédé selon l'une quelconque des revendications 1 à 7, **caractérisé en ce que** l'huile minérale aromatique est une huile à base de xylènes.

9. Procédé selon l'une quelconque des revendications 1 à 8, **caractérisé en ce que** l'huile minérale naphténique a une viscosité inférieure ou égale à 75 mm²/s à 0°C, avantageusement inférieure ou égale à 70 mm²/s à 0°C, en particulier inférieure ou égale à 60 mm²/s à 0°C mesurée selon la norme ASTM D445 avec un viscosimètre Ubbelholde avec des capillaires de diamètre 0,88 mm.

10. Procédé selon l'une quelconque des revendications 1 à 9, **caractérisé en ce que** l'huile minérale naphténique a une tension de vapeur inférieure à 1 Pa à 0°C.

11. Procédé selon l'une quelconque des revendications 1 à 10, **caractérisé en ce que** l'étape de lavage du gaz effluent est réalisée par injection de l'huile minérale dans un courant de gaz effluent parcourant une colonne de pulvérisation.

12. Procédé selon l'une quelconque des revendications 1 à 11, **caractérisé en ce que** huile minérale circule en continu entre un bac de recirculation recueillant l'huile minérale chargée d'hydrocarbures aromatiques polycycliques et au moins une buse de pulvérisation d'huile dans un courant de gaz effluent.

13. Procédé selon la revendication 12, **caractérisé en ce que** l'huile minérale est refroidie sur son trajet entre le bac de recirculation et la ou les buses de pulvérisation.

14. Procédé selon l'une quelconque des revendications 1 à 13 **caractérisé en ce que** le gaz effluent est produit par un procédé de dépôt ou d'infiltration chimique en phase vapeur pour la formation de dépôt de carbone pyrolytique sur des substrats ou pour la densification des substrats poreux par une matrice de carbone pyrolytique.

## Patentansprüche

1. Verfahren zur Behandlung von Abgas, das polycyclische aromatische Kohlenwasserstoffe enthält, welches einen Schritt des Waschens durch Sprühen eines Mineralöls, um die Kohlenwasserstoffe einzufangen, umfasst, **dadurch gekennzeichnet, dass** das Mineralöl ein Gemisch von aromatischem Mineralöl und naphthenischem Mineralöl umfasst, dass das Mineralölgemisch mindestens 20 Volumen-% aromatisches Mineralöl, bezogen auf das Gesamtvolumen des Gemischs, umfasst und dass das Ölgemisch eine Viskosität aufweist, die bei 0 °C kleiner als oder gleich 150 mm²/s ist, gemessen gemäß dem ASTM-Standard D445 mit einem Ubbelohde-Viskosimeter mit Kapillaren mit einem Durchmesser von 0,88 mm.

2. Verfahren nach Anspruch 1, **dadurch gekennzeichnet, dass** das Mineralölgemisch mindestens 30 Volumen-% aromatisches Mineralöl umfasst.

3. Verfahren nach einem der Ansprüche 1 oder 2, **dadurch gekennzeichnet, dass** es eine Initiierungsphase umfasst, in der das Mineralöl kein naphthenisches Mineralöl umfasst und ein aromatisches Mineralöl umfasst, um ein aromatisches Mineralöl zu erhalten, das mit polycyclischen aromatischen Kohlenwasserstoffen beladen ist und eine Viskosität aufweist, die bei 0 °C größer als 150 mm²/s ist, gemessen gemäß dem ASTM-Standard D445 mit einem Ubbelohde-Viskosimeter mit Kapillaren mit einem Durchmesser von 0,88 mm.

4. Verfahren nach Anspruch 3, **dadurch gekennzeichnet, dass** das naphthenische Mineralöl dem Mineralöl zugegeben wird, welches das aromatische Mineralöl umfasst, das mit polycyclischen aromatischen Kohlenwasserstoffen beladen ist und während der Initiierungsphase erhalten wird.

5. Verfahren nach Anspruch 4, **dadurch gekennzeichnet, dass** das zugegebene naphthenische Mineralöl in der Form eines Gemischs von naphthenischem Mineralöl und aromatischem Mineralöl vorliegt und dass die Zugabe durch Austauschen eines Teils des aromatischen Mineralöls, das mit polycyclischen aromatischen Kohlenwasserstoffen beladen ist, durch denselben Volumenanteil des Gemischs von naphthenischem Mineralöl und aromatischem Mineralöl, vorteilhafterweise durch Austauschen von zwischen 20 und 35 % des Volumens des aromatischen Mineralöls, das mit polycyclischen aromatischen Kohlenwasserstoffen beladen ist, erfolgt.

6. Verfahren nach Anspruch 5, **dadurch gekennzeichnet, dass** das zugegebene Ölgemisch mindestens 20 Volumen-% aromatisches Mineralöl, bezogen auf das Gesamtvolumen des Gemischs, vorteilhafterweise mindestens 30 Volumen-% enthält.

7. Verfahren nach einem der Ansprüche 1 bis 6, **dadurch gekennzeichnet, dass** das aromatische Mineralöl einen Dampfdruck aufweist, der bei 0 °C kleiner als 1 Pa ist.

8. Verfahren nach einem der Ansprüche 1 bis 7, **dadurch gekennzeichnet, dass** das aromatische Mineralöl ein Öl auf der Basis von Xylolen ist.

9. Verfahren nach einem der Ansprüche 1 bis 8, **dadurch gekennzeichnet, dass** das naphthenische Mineralöl eine Viskosität aufweist, die bei 0 °C kleiner als oder gleich 75 mm²/s, vorteilhafterweise bei 0 °C kleiner als oder gleich 70 mm²/s, insbesondere bei 0 °C kleiner als oder gleich 60 mm²/s ist, gemessen gemäß dem ASTM-Standard D445 mit einem Ubbelohde-Viskosimeter mit Kapillaren mit einem Durchmesser von 0,88 mm.

10. Verfahren nach einem der Ansprüche 1 bis 9, **dadurch gekennzeichnet, dass** das naphthenische Mineralöl einen Dampfdruck aufweist, der bei 0 °C kleiner als 1 Pa ist.

11. Verfahren nach einem der Ansprüche 1 bis 10, **dadurch gekennzeichnet, dass** der Schritt des Waschens des Abgases durch Einspritzen des Mineralöls in einen Abgasstrom, der eine Sprühkolonne durchströmt, durchgeführt wird.

12. Verfahren nach einem der Ansprüche 1 bis 11, **dadurch gekennzeichnet, dass** das Mineralöl kontinuierlich zwischen einem Rezirkulationstank, der das Mineralöl, das mit polycyclischen aromatischen Kohlenwasserstoffen beladen ist, sammelt, und mindestens einer Düse zum Sprühen von Öl in einen Abgasstrom zirkuliert.

13. Verfahren nach Anspruch 12, **dadurch gekennzeichnet, dass** das Mineralöl auf seinem Weg zwischen dem Rezirkulationstank und der oder den Düse(n) zum Sprühen gekühlt wird.

14. Verfahren nach einem der Ansprüche 1 bis 13, **dadurch gekennzeichnet, dass** das Abgas durch ein Ablagerungs- oder chemisches Dampfphaseninfiltrationsverfahren zur Bildung einer Ablagerung von pyrolytischem Kohlenstoff auf Substraten oder zur Verdichtung von porösen Substraten durch eine Matrix aus pyrolytischem Kohlenstoff produziert wird.

## Claims

1. A process for treating effluent gas containing polycyclic aromatic hydrocarbons comprising a step of spray scrubbing with a mineral oil in order to trap said hydrocarbons, **characterized in that** the mineral oil comprises a mixture of aromatic mineral oil and naphthenic mineral oil, **in that** the mineral oil mixture comprises at least 20% by volume of aromatic mineral oil relative to the total volume of the mixture and **in that** the oil mixture has a viscosity less than or equal to 150 mm²/s at 0°C measured according to the ASTM D445 standard with an Ubbelohde viscometer with capillaries having a diameter of 0.88 mm.

2. The process as claimed in claim 1, **characterized in that** the mineral oil mixture comprises at least 30% by volume of aromatic mineral oil relative to the total volume of the mixture.

3. The process as claimed in any one of claims 1 or 2, **characterized in that** it comprises an initiation phase wherein the mineral oil comprises no naphthenic mineral oil and comprises an aromatic mineral oil, so as to obtain an aromatic mineral oil laden with polycyclic aromatic hydrocarbons and having a viscosity of greater than 150 mm²/s at 0°C measured according to the ASTM D445 standard with an Ubbelohde viscometer with capillaries having a diameter of 0.88 mm.

4. The process as claimed in claim 3, **characterized in that** naphthenic mineral oil is added to the mineral oil comprising aromatic mineral oil laden with polycyclic aromatic hydrocarbons obtained during the initiation phase.

5. The process as claimed in claim 4, **characterized in that** the naphthenic mineral oil added is in the form of a mixture of naphthenic mineral oil and aromatic mineral oil and that the addition is carried out by replacing a portion of the aromatic mineral oil laden with polycyclic aromatic hydrocarbons with the same proportion by volume of the mixture of naphthenic mineral oil and aromatic mineral oil, advantageously by replacing between 20% and 35% of the volume of the aromatic mineral oil laden with polycyclic aromatic hydrocarbons.

6. The process as claimed in claim 5, **characterized in that** the oil mixture added contains at least 20% by volume of aromatic mineral oil relative to the total volume of the mixture, advantageously at least 30% by volume.

7. The process as claimed in any one of claims 1 to 6, **characterized in that** the aromatic mineral oil has a vapor pressure of less than 1 Pa at 0°C.

8. The process as claimed in any one of claims 1 to 7, **characterized in that** the aromatic mineral oil is a xylene-based oil.

9. The process as claimed in any one of claims 1 to 8, **characterized in that** the naphthenic mineral oil has a viscosity less than or equal to 75 mm²/s at 0°C, advantageously less than or equal to 70 mm²/s at 0°C, in particular less than or equal to 60 mm²/s at 0°C, measured according to the ASTM D445 standard with an Ubbelohde viscometer with capillaries having a diameter of 0.88 mm.

10. The process as claimed in any one of claims 1 to 9, **characterized in that** the naphthenic mineral oil has a vapor pressure of less than 1 Pa at 0°C.

11. The process as claimed in any one of claims 1 to 10, **characterized in that** the step of scrubbing the effluent gas is carried out by injecting mineral oil into an effluent gas stream travelling through a spray tower.

12. The process as claimed in any one of claims 1 to 11, **characterized in that** the mineral oil circulates continuously between a recirculation tank that receives the mineral oil laden with polycyclic aromatic hydrocarbons and at least one spray nozzle for spraying oil into an effluent gas stream.

13. The process as claimed in claim 12, **characterized in that** the mineral oil is cooled over its path between the recirculation tank and the spray nozzle(s).

14. The process as claimed in any one of claims 1 to 13, **characterized in that** the effluent gas is produced by a chemical vapor infiltration or deposition process for the formation of a pyrolytic carbon deposit on substrates or for the densification of porous substrates by a pyrolytic carbon matrix.
